(19)

Europäisches
Patentamt

European
Patent Office

Office européen
des brevets

(11) **EP 3 904 898 A1**

(12) **EUROPEAN PATENT APPLICATION**

(43) Date of publication:
**03.11.2021 Bulletin 2021/44**

(51) Int Cl.:
**G01R 33/44** *(2006.01)*　　　**G01R 33/50** *(2006.01)*

(21) Application number: **20172381.4**

(22) Date of filing: **30.04.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Erasmus University Rotterdam Medical Center**
**3015 GE Rotterdam (NL)**

(72) Inventors:
- **HERNÁNDEZ TAMAMES, Juan Antonio**
  **3015 GE Rotterdam (NL)**

- **KOTEK, Gyula**
  **3015 GE Rotterdam (NL)**
- **NUÑEZ GONZÁLEZ, Laura**
  **3015 GE Rotterdam (NL)**
- **VOGEL, Mika**
  **3015 GE Rotterdam (NL)**
- **POOT, Dirk**
  **3015 GE Rotterdam (NL)**

(74) Representative: **V.O.**
**P.O. Box 87930**
**2508 DH Den Haag (NL)**

(54) **BALANCED PHASE CYCLING NON STATIONARY FREE PRECESSION SEQUENCE; BANDING ARTIFACT FREE IMAGING FOR MR MULTI-PARAMETRIC ESTIMATION**

(57)　　An MR excitation sequence comprises a repeated block (A) of excitation pulses. Each block (A) comprises a set of interleaved RF pulses with alternating small and large flip angle $(\alpha,\gamma)$ applied along different axes (x,y) to form a balanced sequence such as $\alpha_x,\gamma_y,\alpha_y,\gamma_x$. The sequence is simultaneously sensitive to various parameters such as PD, T1, T2, B1 and B0 keeping a high coherence and avoiding the formation of banding artifacts.

FIG 10

**EP 3 904 898 A1**

**Description**

TECHNICAL FIELD AND BACKGROUND

The present disclosure relates to an advantageous new sequence of pulses for acquiring MR data.

Magnetic resonance imaging (MRI) is used extensively in medicine and biology. It provides meaningful images of different organs and pathologies based on the magnetic properties of select nuclei present in tissues. However, MRI in current practice evolved mainly as a qualitative tool, based on "weighted" contrasts instead of exploiting absolute quantitative information. There are good reasons for this: accuracy and precision in absolute quantification require long scan times and, moreover, are challenging because of the high sensitivity to MR system imperfections such as magnetic field (known as $B_0$) inhomogeneity and/or radiofrequency pulse (known as $B_1^+$) inaccuracies. These factors make quantitative reproducibility across different experimental conditions and MR systems difficult.

In order to overcome these difficulties, Magnetic Resonance Fingerprinting (MRF) has recently emerged as a new paradigm for quantitative MR imaging [Ma D, Gulani V, Seiberlich N, Liu K, Sunshine JL, Duerk JL, et al. Magnetic resonance fingerprinting. Nature. 2013;495(7440):187.]. MRF is the first approach using the magnetization transient response to simultaneously obtain quantitative parametric maps of the intrinsic tissue properties such as $T_1$ (longitudinal relaxation time) $T_2$ (transverse relaxation time) and proton density (PD). This method suggests that the variation of the sequence parameters is essential in generating a unique signal evolution for each tissue. It consists of a pseudorandom acquisition based on the same mathematical principles as compressed sensing [Lustig M, Donoho DL, Santos JM, Pauly JM. Compressed sensing MRI. IEEE signal processing magazine. 2008;25(2):72] that, previously, was successfully applied to reconstruct fast MR imaging acquisitions. This approach, however, is not based on an analytical description of the signal evolution. In order to obtain quantitative maps, it requires an *a priori* dictionary of signals combined with a matching process to find the signal closest to the one acquired. A similar but faster alternative, Quantitative Transient Imaging (QTI), was recently published [Gómez PA, Molina-Romero M, Buonincontri G, Menzel MI, Menze BH. Designing contrasts for rapid, simultaneous parameter quantification and flow visualization with quantitative transient-state imaging. Scientific reports. 2019;9(1):8468] using a fixed time of repetition (TR) and a linearly increasing variable flip angle (vFA).

Dictionary matching is a powerful method in quantitative MR but has four important drawbacks. First, dictionaries are bound to the acquisition design and settings. Due to the lack of an analytical expression, optimization is only possible in a circular trial-and-error approach. Second, the resolution of the dictionary depends on the particular range of values of the parameters to be detected. Hence, creating a dictionary that provides uniform accuracy for any range of the parameter values is challenging. Third, to additionally include MR system imperfections in the dictionary construction could make the dictionary impractically large and thus its management cumbersome. And fourth, the dictionary is usually restricted to *a priori* ranges of standard values from healthy subjects that may not include unexpected values associated with pathologies of interest. Taken together, these shortcomings foster the need for an analytical description of the signal evolution.

The inventors previously disclosed an innovative method for magnetic resonance imaging in the international patent publication WO 2020/0046120. To avoid unnecessary repetition of the theoretical groundwork and possible implementations, the entire contents of said WO publication are incorporated herein by reference.

There is a need for further improvement in magnetic resonance imaging, e.g. to provides a sequence that is simultaneously sensitive to various parameters such as PD, T1, T2, B1 and B0 keeping a high coherence and avoiding the formation of banding artifacts.

SUMMARY

We present and evaluate a relevant and novel insight into quantitative magnetic resonance imaging. It is based on an algebraic description of the magnetization during the transient response. We exploit the correspondence between the signal evolution as a result of a repetitive sequence of radiofrequency excitation pulses, the continuous Bloch equations and a system of dissipative coupled harmonic oscillators. This approach simultaneously provides, in a single measurement, all quantitative parameters of interest as well as the system imperfections. It surpasses previous attempts like Magnetic Resonance Fingerprinting and Quantitative Transient Imaging in exploiting the magnetic resonance transient response. Moreover, our approach does not require any dictionary to estimate the parameters - instead obtaining all the maps at once in a single measurement. Finally, we demonstrate the applicability and advantages of the new concept on a clinical MRI scanner.

Here we introduce a new method that we name *Comprehensive MR Imaging.* It builds on a formalism proposed by Skinner in 2018 [Skinner TE. Comprehensive solutions to the Bloch equations and dynamical models for open two-level systems. Physical Review A. 2018;97(1):013815] that naturally continued Torrey's seminal work published almost 70 years earlier in 1949 [Torrey HC. Transient Nutations in Nuclear Magnetic Resonance. Physical Review. 1949;76(8):1059-68]. Until now, the most simple and manageable way of describing the transient response had been to use the recurrent matrix formulation established by Jaynes [Jaynes ET. Matrix treatment of nuclear induction. Phys Rev. 1955;98(4):1099-105] and Bloom Bloom AL. Nuclear induction in inhomogeneous fields. Physical Review. 1955;98(4):1105] in 1955. Nevertheless, as stated by Jaynes himself and even Lauterbur in Lian & Lauterbur [Liang Z-P, Lauterbur PC. Principles of magnetic resonance imaging: a signal processing perspective: SPIE Optical Engineering Press; 2000] more recently, this formulation is "tedious and not very intuitive". The only attempt to use a closed-form to measure $T_1$ and $T_2$ from the transient response had been proposed in the early days of MR by aforementioned Torrey - "The Road not Taken" -, but only for a single RF pulse. More than 50 years later, in 2003, Scheffler [Scheffler K. On the transient phase of balanced SSFP sequences. Magn Reson Med. 2003;49(4):781-3] suggested but did not fully develop the possibility of estimating T1 and T2 from the transient response. However, despite Torrey's early works and more recent related proposals, this road was not taken by the MR Imaging community. Therefore, we herein extend Torrey's solution for parameter estimation to an entire sequence of pulses. We describe the magnetization and the detected signal by the dynamic evolution of a dissipative system of three coupled harmonic oscillators [see aforementioned Skinner 2018]. We present a comprehensive analytical closed-form equation describing the signal evolution, including every parameter involved in the transient magnetization response. The resulting signal obtained, which we call the *Signature,* resembles the free induction decay (FID) - but stretched along the multiple RF pulses allowing for simultaneous measurements of PD, $T_1$, $T_2$, $B_0$ and $B_1^+$.

We demonstrate that the resulting signal evolutions are distinct for different species and provide the basis for accurate, intrinsic parameter estimation without changing the acquisition parameters. Furthermore, we argue that an explicit analytical description of the signal evolution is desirable in optimizing the acquisition sequence. Thanks to the analytical description, simple curve fitting can be applied for parameter quantification avoiding pattern-recognition-type estimations.

In order to fully exploit the possibilities of our method, we further propose a new acquisition sequence that enhances the performance of the model by preserving the spin coherence despite any intravoxel $B_0$ inhomogeneities, while remaining sensitive to overall $B_0$. The images obtained with this sequence show an excellent contrast between tissues and good accuracy and precision in both a standardized phantom and *in-vivo,* demonstrating the good performance of the proposed model.

In describing the signal evolution during the acquisition we do not rely on the concept of echo formation. As such, from a conceptual point of view, our approach is a completely new non-heuristic alternative to spin-echo, gradient echo or steady state quantitative imaging.

In order to provide a deeper understanding of quantitative MR imaging outputs, an analytical closed-form expression describing the magnetization is needed. In the present disclosure we present a new method that we named *Comprehensive MR Imaging* based on a dissipative 3D coupled harmonic oscillator (DCHO) model. This model provides a deeper understanding of MR relaxometry as well as better predictions for pulse sequence design.

Our approach represents "the road not taken" in the field of MR in that the closed-form analytical description presented in the present disclosure, as well as the associated pulse sequence, were thus far not exploited. This new approach is obviously different than previously proposed steady state techniques but also constitutes an alternative concept to both the spin-echo as well as the gradient echo concepts. In describing the signal evolution, we do not rely on the concept of echo formation. This is also a new interpretation and complete non-heuristic characterization of the transient response, different from MRF and QTI, based on DCHO.

Moreover, unlike MRF and QTI, our approach does not require any dictionary to estimate the parameters or vary the acquisition setting. The signal evolution is perfectly described by the closed-form expression and it can be directly fitted with the DCHO model obtaining all the maps in a single measurement.

These features set the current development apart from other simultaneous, multi-parametric techniques as they require either additional scans for estimating $B_1^+$ and $B_0$, or depend on more *a priori* information in the dictionary. Moreover, these additional acquisitions for $B_1^+$ and $B_0$ estimation are important sources of variability in terms of motion artifacts, different slice profiles, physiological noise and longer scan times. However, with the method here proposed, the $B_0$ inhomogeneity is estimated and hence does not confound the assessment of the other parameters. Our model also takes into account $B_1^+$ variation, reducing fidelity requirements of the applied RF pulses. Also, it intrinsically minimizes the effect of unavoidable system imperfections. The simultaneous estimation of $B_0$ and $B_1^+$ promises to make the parametric maps insensitive to system degradation rendering the estimation more robust and repeatable - even between disparate scanners and/or sessions.

Thus, as this new approach gives an all-inclusive set of tissue properties ($T_1$, $T_2$ and PD) without confounding by $B_1^+$ and $B_0$, that are also estimated in one measurement, our method constitutes *Comprehensive MR.*

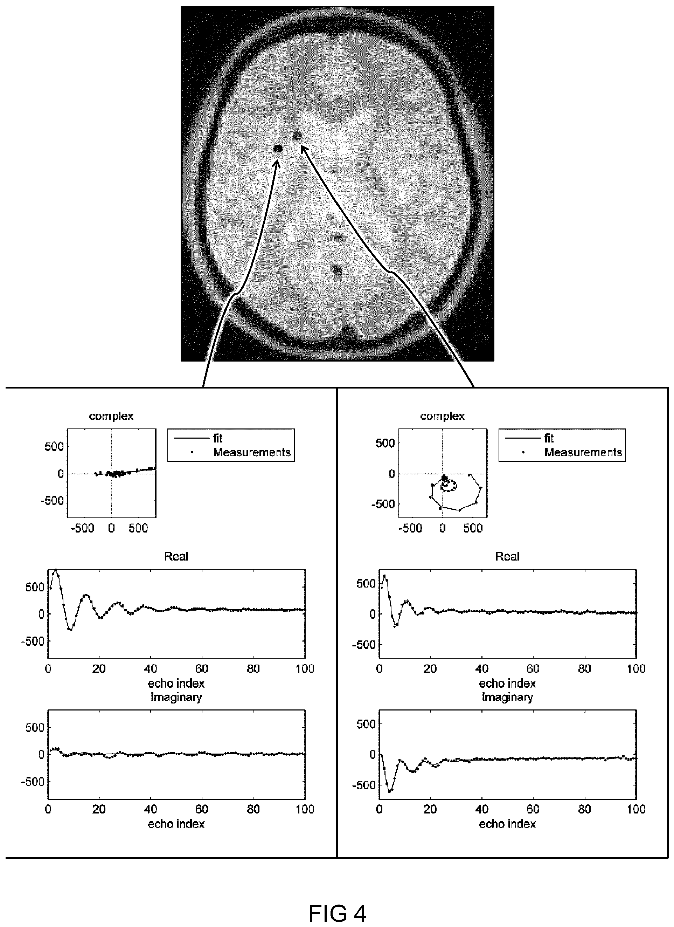

The signal obtained with the DCHO, termed here *MR Signature,* resembles a stretched FID because of the close analogy to the free induction decay from Torrey's solution of the Bloch equations. The *MR Signature* has a frequency that is mainly determined by external controllable parameters (excitation flip angle and $\beta$) while the decay of the amplitude is mainly determined by the relaxation processes. As the signal is unique for each tissue, it may be considered to be the *signature* of the tissue (figure 4).

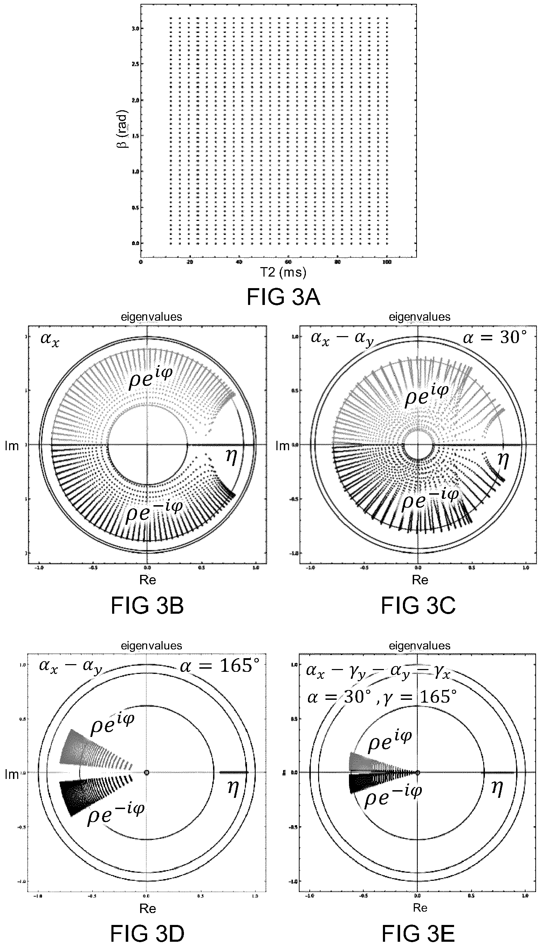

The DHCO model also explains the crucial role of the phase, $\beta$, accumulated in a propagator block. In some SSFP sequences, $\beta$ is purposely manipulated with phase-cycling, or multiple bSSFP sequences are played out with excitation phase variations in order to avoid banding artifacts. In SPGR sequences $\beta$ is manipulated as well, so as to spoil off-resonance spins. With DCHO, we see that the signal evolution is largely insensitive to $\beta$, thus avoiding banding artifacts and eigenvalues warping that could hinder the estimation of parametric maps. Still, sensitivity to $T_1$, $T_2$, PD, and $\beta$ is maintained (figure 3).

*Comprehensive MR* can provide unique *MR Signatures* of healthy or pathological conditions and this will be explored in further studies. In all the tissues that we have examined thus, the *MR Signature* can be characterized after 50 pulses with a TR less than 10ms. A limitation of the current implementation is that full k-space sampling is needed, requiring multiple repeats of the acquisition. Furthermore, obtaining multiparametric maps, in a single measurement of less than 500ms per slice, is feasible when combining parallel imaging and compressed sensing techniques.

As shown in our *in-vitro* results, the accuracy for $T_2$ values is high and only $T_1$ shows a systematic linear bias that could be explained by the well-known magnetization transfer effect.

The experimental proof of concept was performed with 2D acquisitions. However, the concept allows direct extension to 3D acquisitions. Such extension facilitates high-spatial resolution with isotropic voxels. Parallel imaging and (deep learning based) compressed sensing acceleration factors can also be incorporated.

Illustrative of "the road not taken", our work demonstrates the applicability of the DCHO model in combination with a novel MR acquisition technique (MP-b-nSSFP) to generate a distinct signal (*MR Signature*) capable of characterizing any tissue for quantitative MR (*Comprehensive MR Imaging*). This new technique is less affected by common system imperfections allowing for the development of new (less-demanding) MR scanners. Finally, based on the robustness of the simultaneous estimation of experimental conditions and parametric maps, our method paves the way towards standardization of MR technology.

In a preferred embodiment a balanced sequence of repetitive blocks is applied until getting the stationary state. One repetitive block comprises four pulses interlacing small flip angles (alpha) and large flip angle pulses and alternating the phase as follows: $\alpha_x$-$\gamma_y$-$\alpha_y$-$\gamma_x$, being remarkable the phase scheme (x-y-y-x). Between every pair of adjacent RF pulses the signal is e.g. sampled with balanced spiral-out k-space trajectory. After the first "$\alpha_x$" pulse the signal is proportional to PD. After any "$\gamma_x$" or "$\gamma_y$" pulse, the signal is refocused before the next "$\alpha_x$" or "$\alpha_y$" maximizing the transversal signal after any "$\alpha$" pulse. The phase accumulates a constant precession angle, due to field inhomogeneities, local susceptibility gradients or chemical shift after any "alpha". This feature makes the sequence sensitive to B0 field inhomogeneities. In summary, the transversal magnetization is sensitive to all the relevant parameters T1, T2, PD, B1, B0. The particular phase cycling being used combines small flip angles and large flip angles keeping the intra-voxel magnetization as a single species away from the axis x and y of the rotating frame of reference avoiding typical banding artifact. The parameter estimation and the interpretation of the transient signal is compatible with different mathematical methods: either a vectorial equation derived from our previous patent application WO 2020/0046120, or Bloch equations or a dictionary as in MR Fingerprinting or Quantitative Transient Imaging.

The simultaneous estimation of MR parameters or maps have been recently achieved with different approaches: MR Fingerprinting, MAGIC, QTI or MR Signature. MR Fingerprinting and QTI can be implemented with balanced or spoiled unbalanced SSFP sequences. They are sensitive to PD, T1 and T2 but they are not sensitive to B1 or B0, despite being a balanced sequence. They require either specific B1 corrections and to increase the dictionary with signal evolutions affected by different off-resonance effects. MAGIC is sensitive to PD, T1, T2 and insensitive to B0 because it uses a spin-echo sequence and it requires an additional B1 correction. The present disclosure provides a sequence simultaneously sensitive to PD, T1, T2, B1 and B0 keeping a high coherence any avoiding the formation of banding artifacts. Regarding other simultaneous quantitative MR methods such as MR Fingerprinting, QTI or MAGIC, the sequence is sensitive to all the relevant parameters. Regarding MRF, it does not require to incorporate B0 information in the dictionaries as the B0 map can be estimated and the dictionary itself is not necessary. Regarding other balanced SSFP sequences, it intrinsically avoids the formation of banding artifacts.

BRIEF DESCRIPTION OF DRAWINGS

These and other features, aspects, and advantages of the apparatus, systems and methods of the present disclosure will become better understood from the following description, appended claims, and accompanying drawing wherein:

FIG 1A illustrates an example block;

FIG 1B illustrates an example sequence of repeated blocks;

FIGs 2A-2F illustrate evolution of a magnetization vector in three dimensions and in respective projections;

FIGs 3A-3E illustrate mapping of eigenvalues for various excitation schemes;

FIG 4 illustrates an image derived with the present methods and underlying measurement and fitted traces of the magnetization;

FIGs 5A and 5B illustrates estimates of T1 and T2 for various samples as function of their reference value;

FIGs 6A-6F illustrate various images generated with the present methods including a new type of image contrast $\rho^2\eta$;

FIG 7A illustrates various parameters such as magnetic fields and flip angles;

FIG 7B illustrates a preferred sequence of repeated blocks;

FIG 7C illustrates a magnetization as function of block number;

FIGs 8A and 8B illustrate representative graphs which can be used to verify an optimal combination of small and larger flip angles;

FIG 9 illustrates a repeated block in an MR sequence with Cartesian readout;

FIG 10 illustrates a repeated block in an MR sequence with spiral readout.

DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise.

Applications of NMR, such Magnetic Resonance Imaging (MRI), typically relies on a constant, homogeneous magnetic field "B0" to polarize spins in a target volume of an object to be imaged. The direction of B0 can be used define the longitudinal axis, denoted as the "z-axis"; and the transverse directions along the "x-axis" and "y-axis" (perpendicular the longitudinal axis and each other). The B0 field can create a magnetization "$\mu$" of the spins which in equilibrium is directed along the z-axis. The magnetization can be excited (out of equilibrium) and detected at the resonance frequency of the spins in the magnetic field, referred to as the Larmor frequency. The Larmor frequency varies with magnetic field strength, and is normally in the radio frequency (RF) range.

A radio frequency (RF) energy field "B1" can be applied perpendicular to the longitudinal axis (B0) to perturb the magnetization in some manner. The flip angle "$\alpha$" (or "$\gamma$") refers to the angle to which the net magnetization is rotated or tipped relative to the main magnetic field direction via the application of an RF excitation pulse at the Larmor frequency $F_L$. It is also referred to as the tip angle, nutation angle or angle of nutation. The radio frequency power (which is proportional to the square of the amplitude) of the pulse is proportional to "$\alpha$" through which the spins are tilted under its influence.

The angle of the magnetization in the transverse plane is also referred to as the phase. It will be understood that the "RF pulse" is merely a magnetic field (B1) of short duration rotating at the Larmor frequency in the transverse plane (xy). Depending on its phase, the RF pulse may be considered to be "directed" along the x-axis or $\gamma$-axis (or anywhere else in between). In a sequence or block, RF pulses can be applied along different axes by shifting the relative phase between the RF pulses. For example, a first RF pulse is applied along the x-axis followed by a second RF pulse applied along the $\gamma$-axis by phase shifting the excitation ninety degrees between the pulses.

A spatially varying magnetic field, i.e. gradient, can used to manipulate the resonance frequency across an object for selectively exciting and/or detecting spins in a specific region of the object. MRI scanners typically incorporate gradient coils to vary a magnitude the magnetic field B0 with gradients "Gx", "Gy", and "Gz" along the x-, y-, and z-directions, respectively. The strength of the respective gradients can typically be controlled by a magnetic gradient pulse sequence which can be rapidly manipulated (or "switched").

The invention is described more fully hereinafter with reference to the accompanying drawings. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

*Theoretical framework - From Linear Algebra to Dissipative Coupled Harmonic Oscillators*

We start with a detailed theoretical description which may help in understanding various application for improvement in the field of MR. However it will be understood that practical applications are not bound by details of this theory or the specific examples provided for explaining the various aspects. Instead, this is merely provided to convey a good understanding of the principles, while the scope of applications may include various combinations and/or extensions of these aspects.

Without being bound by theory, we provide an algebraic description of the signal evolution during the entire MR sequence. Our goal is to establish a theoretical background for quantitative sequences that utilizes a single transient response and can yield quantitative maps for all relevant parameters, intrinsic ($T_1$, $T_2$, PD) and experimental ($B_0$ & $B_1^+$), at once.

*Linear operators - the propagator*

An MRI sequence typically consist of a train of acquisition blocks, here called *propagators,* sequenced in a repetitive manner. Each block typically consists of radiofrequency excitations, magnetic field gradients and waiting times (periods absent of RF excitations or magnetic field gradients). The excitations, gradients and free precession can be represented by rotations of the magnetization that can be described, e.g., as linear operators.

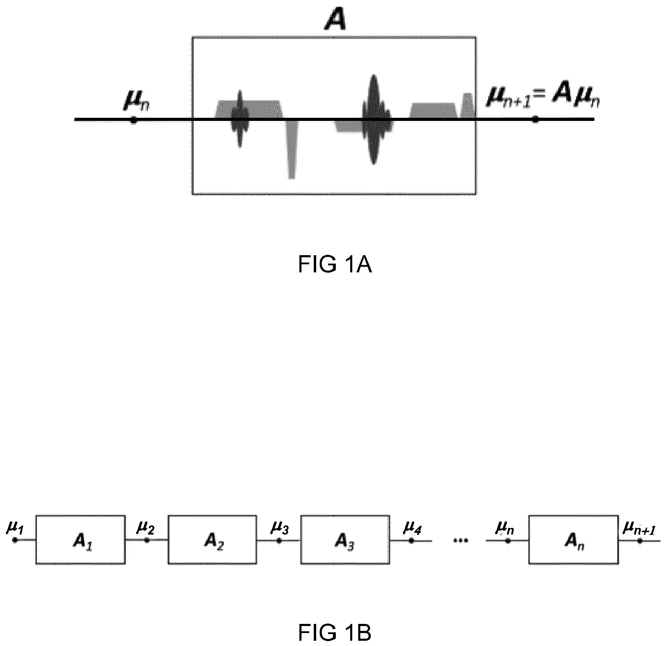

FIG 1A illustrates an example "propagator": a single block of events. $\mu$ is the input-output magnetization, in dark gray the RF excitations and in light gray the gradients. FIG 1B illustrates a train of blocks in an MR pulse sequence. We will use identical blocks or operators A $=A_1=A_2=...=A_n$.

The cumulative effect of the events within an entire block can be represented by a single operator resulting from the linear product of rotations and relaxations. We focus on a special case when the propagator, *A,* is identical along the train. Typically, the evolution of the magnetization can be modelled by the recursive application of the Bloch equation. However, as introduced by Skinner, the evolution of the magnetization can also be modelled as a second order differential equation of motion for dissipative coupled harmonic oscillators. This is shown in equations *A1*, *A2* and A3 (see *Appendix* section for mathematical details).

This connection provides three relevant consequences: first, the magnetization and, therefore the signal, follows a damped oscillatory pattern; second, the signal obtained resembles a stretched FID sensitive to all the intrinsic and experimental parameters ($T_1$, $T_2$, PD, $B_0$ & $B_1^+$); third, the DCHO model provides an alternative formulation with different intrinsic parameters, the eigenvalues, that allows for an alternative analysis of the pulse sequence (see Appendix for mathematical details).

*Dissipative Coupled Harmonic Oscillator Model*

This DHCO model provides a comprehensive interpretation of the signal in terms of intrinsic and experimental parameters. The damped oscillation is determined by the propagator, *A,* and this propagator can be fully and directly described by its eigenvalues.

The eigenvalues with the initial state provide an exact and compact solution in a closed-form:

$$\boldsymbol{\mu}_n = \rho^n \cdot \sin(n\varphi) \cdot \boldsymbol{v}_1 + \rho^n \cdot \cos(n\varphi) \cdot \boldsymbol{v}_2 + \eta^n \cdot \boldsymbol{v}_3 \qquad (1)$$

where $\mu_n$ is the 3D magnetization vector after the subtraction of the steady state. $\rho e^{i\varphi}$, $\rho e^{-i\varphi}$ and $\eta$ are the eigenvalues of the propagator $\boldsymbol{A}$, with real $p$ and $\eta$. $\varphi$ is mostly real (it is purely imaginary only in the special overdamped, on-resonance case). $v_1$, $v_2$, $v_3$ are the normal modes of the 3D harmonic oscillator.

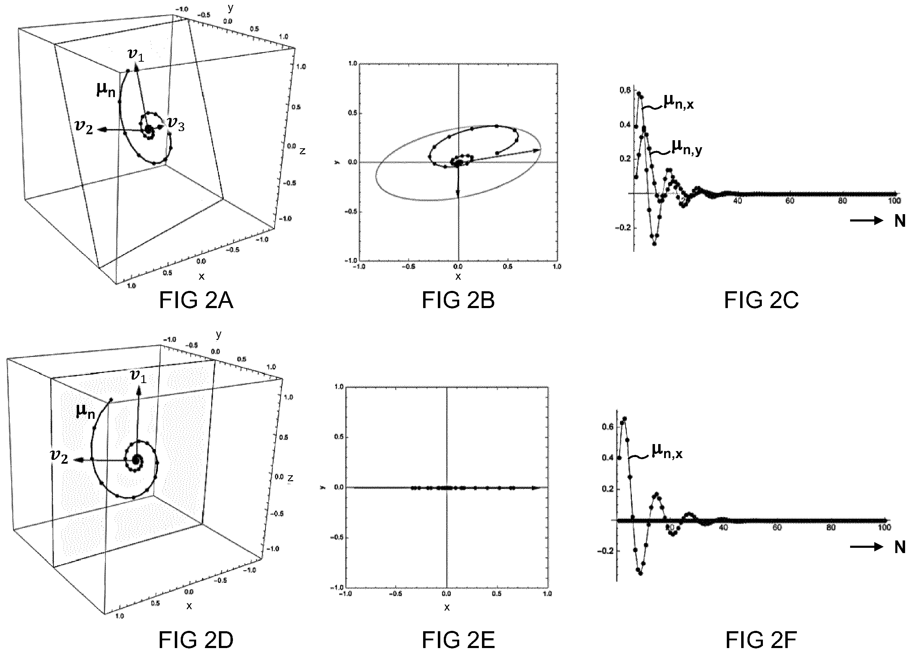

FIGs 2A-2C illustrate evolution of the magnetization where the repeated block consists of an excitation with flip angle $\alpha$=30°, $\beta$=14° (accumulated phase as a result of off-resonance during $T_R$, $T_R$=10 ms), relaxation times are $T_1$ = 878 ms, $T_2$= 47.5 ms. The vectors $v_1$ and $v_2$ span the plane of oscillation. In this case, the magnetization vector always points to a point of this plane. Only the orientation of the plane is fixed throughout the evolution; it shifts parallel to $v_3$.

FIGs 2D-2F are similar to FIGs 2A-2C but on-resonance ($\beta$=0°). The plane spanned b. $v_1$ and $v_2$ is the x-z plane throughout the entire evolution. The points represent the magnetization difference vector and its evolution along the sequence as according to Eqn.A1. The continuous line is the corresponding continuous case of Eqn.A2. It is not the fully continuous trajectory of the magnetization. However, the magnetization at the discrete time points sit on the continuous curve.

FIGs 2A and 2D illustrate evolution of the magnetization in three dimensions; FIGs 2B and 2E illustrate the x-y projection (transversal plane); FIGs 2C and 2F illustrate x and y component (signals measured in quadrature).

*Design of a pulse sequence based on the analysis of the eigenvalues of the propagator*

This section demonstrates how to properly design a propagator for a pulse sequence based on a simple analysis of its eigenvalues, in order to produce a signal evolution for simultaneous estimation of parametric maps: $T_1$, $T_2$, proton density (PD), $B_0$ and $B_1^+$. The consequence of this appropriate design is to produce an optimal signal evolution enhancing the effects of the desired parameters and suppressing undesired confounders (like $B_0$ inhomogeneities or $B_1^+$ imperfections).

Theoretically, any propagator with at least one RF excitation pulse could suffice for $T_1$, $T_2$ and PD mapping. In practice, however, a careful choice of the propagator is desired in order to provide sensitivity for a large range of parameters and also to maintain robustness of parameter estimation despite uncontrolled variations in experimental parameters.

FIGs 3A-3E show the mapping of a $T_2$-$\beta$ parameter space to the eigenvalue complex plane. FIG 3A shows $T_2$-$\beta$ species: parameter space; FIGs 3B-E are the eigenvalue maps where three eigenvalues belong to each parameter species: the complex eigenvalues ($\rho e^{i\varphi}$, $\rho e^{-i\varphi}$), and the real eigenvalue ($\eta$). In more detail, we take a two-dimensional plane $T_2$-$\beta$ (with fixed $T_1$ and excitation flip angle) (FIG 3A) and look at the resulting eigenvalue space in the complex plane (FIGs 3B,3C,3D,3E for different sequences or propagators), where each $T_2$-$\beta$ species are represented by three eigenvalues. For all of them $T_1$=878 ms, $T_R$=12 ms.

In order to illustrate the propagator design process we consider a two-dimensional plane $T_2$-$\beta$ (where $\beta$ is the accumulated phase during a TR due to off-resonance) (FIG 3A), with fixed $T_1$ and excitation flip angle. FIGs 3B-3E show the resulting eigenvalue space in the complex plane for different sequences or propagators. According to the 3D DCHO model, each $T_2$-$\beta$ species is represented by three eigenvalues. As will be appreciated, the eigenvalue space can provide immediate insight into the signal evolution: the radial distance from the origin determines the decay rate, and the angular position determines the oscillation frequency of the stretched FID to be detected.

We next evaluated different pulse sequences based on different propagators. We simulated propagators based on one single pulse with flip angle "$\alpha$", with fixed arbitrary value of 30°, and played out along "x" ($\alpha_x$). We then modified either the phase (playing out the pulse along "y" instead of along "x", "$\alpha_y$") or the flip angle "$\gamma$" (165°). To illustrate how to perform the eigenvalues-based analysis, we used four different repetitive propagators to design the pulse sequence: "$\alpha_x$", "$\alpha_x$ - $\alpha_y$", "$\alpha_x$ - $\gamma_x$ - $\alpha_y$ - $\gamma_y$" and "$\alpha_x$ - $\gamma_y$ - $\alpha_y$ - $\gamma_x$". The last two are almost equivalent so, from now on, we refer only the last one: "$\alpha_x$ - $\gamma_y$ - $\alpha_y$ - $\gamma_x$".

The "$\alpha_x$" and the "$\alpha_x$ - $\alpha_y$" propagators show radial dependence on $T_2$ and angular dependence on $\beta$ in the eigenvalue space. In the proximity of $\beta$ = 0 the eigenvalue space is warped and thus would hinder differentiating between different $T_2$-$\beta$ species. The "$\alpha_x$-$\alpha_y$" propagator shows similar patterns for low excitation flip angles and also, the eigenvalue space is wrapped around for species between $\beta$ = 0 - $\pi$/4 and $\beta$ = $\pi$/4 - $\pi$/2. For higher values of $\alpha$, the positions of $\beta$ = 0 species are swapped to the negative real half-plane and the warping disappears. The "$\alpha_x$ - $\gamma_y$ - $\alpha_y$ - $\gamma_x$" propagator shows the same features as the "$\alpha_x$ - $\alpha_y$" propagator for larger flip angles.

Besides the undesired warping, there is yet another problem arising in the near-resonance for "$\alpha_x$" and "$\alpha_x$ - $\alpha_y$", in particular with lower $\alpha$. The trajectory becomes two-dimensional and the third normal mode vector $v_3$ vanishes (this can be observed in Figures 2.d and 2.e). In equation 1, the third term becomes zero and consequently, the signal (Figure 2.f.) carries no information about the real eigenvalue $\eta$.

The criteria in selecting the propagator are the following: first, the eigenvalue space preferably should carry information on $T_1$, $T_2$ and $\beta$ and second, the resulting eigenvalue space preferably should not have warping so as to avoid incorrect estimations for different tissues.

The "$\alpha_x$ - $\alpha_y$" propagator may be optimal from a conceptual perspective: it avoids warping and provides radial-angular distribution. However, it is technically challenging, especially in a 2D scan for higher flip angles, where a sharp slice profile is desired.

Therefore it is beneficial to choose a propagator where the $\beta$ dependence of the eigenvalue space is limited but not absent. This allows voxels to be described as single species, even if some intra-voxel dispersion in $\beta$ exists, while at the same time allowing determination of $B_0$. Additionally, these limited $\beta$ values can also be interpreted as minimum dephasing. This is an important advantage that eliminates typical banding artifacts in bSSFP sequences.

We experimentally verified these theoretical predictions and found that the propagator "$\alpha_x$ - $\gamma_y$ - $\alpha_y$ - $y_x$" showed the best performance due to the minimal $\beta$ dispersion. This propagator then is the building block of the new sequence that we named "Multi-Phase balanced, non-Steady State Free Precession" (MP-b-nSSFP).

*Demonstration of the DCHO signal evolution on a clinical scanner*

The "in-vivo" study in healthy subjects was approved by the institutional review board (protocol 2014-096) and a written informed consent was obtained from the volunteer. For the validation we used a 1.5 T clinical scanner - the GE Optima MR450w (General Electric Medical Systems, Waukesha, WI) with a 16 channel head and neck coil. We could demonstrate that the proposed theoretical framework describes the experimental signal evolution with great accuracy. The acquisition was carried out by 100 times repeated 2D spiral readouts with a TR of 10 ms. For complete data collection, this experiment was repeated in 64 different spiral rotations.

FIG 4 shows measured data and theoretical model fit for the "$\alpha_x$" propagator. The theoretical DCHO model (see equation 1) closely matches the data points. The 2D signal plot clearly shows that the selected voxel is not on-resonance (compare to FIGs 2B and 2C). Despite the presence of external field ($B_0$) inhomogeneities, the single species DCHO model describes the signal evolution remarkably well. It is also important to note that, due to the minimum dephasing, banding artifacts are lacking - as predicted by the analysis described above (FIG 3).

In FIG 4, the signal is shown as it evolves along the echo train in two voxels (depicted on the anatomical image) with the "$\alpha_x$ - $\gamma_y$ - $\alpha_y$ - $\gamma_x$" propagator. The anatomical image is shown on top. The bottom left subfigures shows the respective voxel, where the spins are on-resonance. The bottom-right subfigure (other voxel) shows a spiral in the complex signal plane. This clearly shows the regularity of the evolution. The orthogonal real and imaginary components are depicted. The frequency of the oscillations is constant, the decay of the amplitudes is exponential. The steady state is not zero. The fitted curves show the fitted harmonic oscillator model.

*Validation in a standardized phantom - Accuracy and Precision*

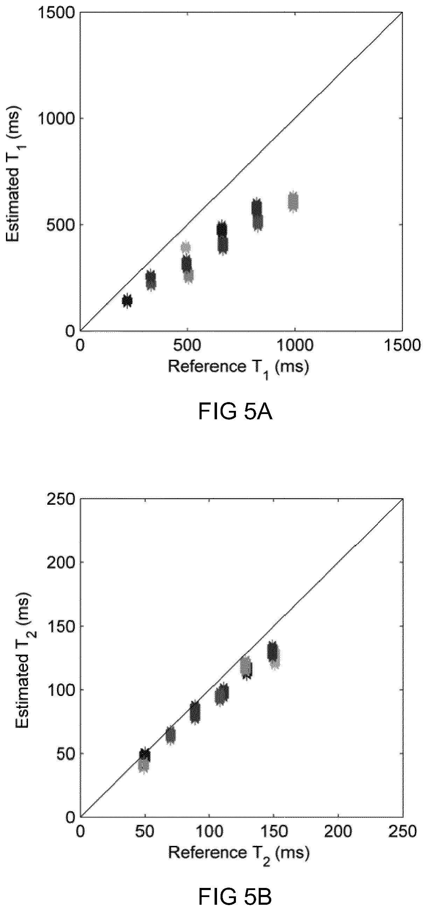

FIGs 5A and 5B shows the correlation between the nominal and the DCHO derived parameters. We tested the DCHO model in a standard phantom set (ISMRM/NIST MR System Phantom). Voxels from the same phantom tube are depicted with the same grayscale. The parameters were derived from data acquired with the" $\alpha_x$ - $\gamma_y$ - $\alpha_y$ - $\gamma_x$"propagator. The mean $T_2$ is underestimated by 10% ($\pm$ 4%). The accuracy of the $T_1$ maps is lower as the mean $T_1$ values are underestimated by 34% ($\pm$ 8%). The overall bias shows a linear dependence on the $T_1$ values. Apart from the bias, the precision of the $T_1$ maps is in the range of 10ms. This shows that both parameters are estimated independently with high voxel-wise precision.

*In-vivo parametric maps*

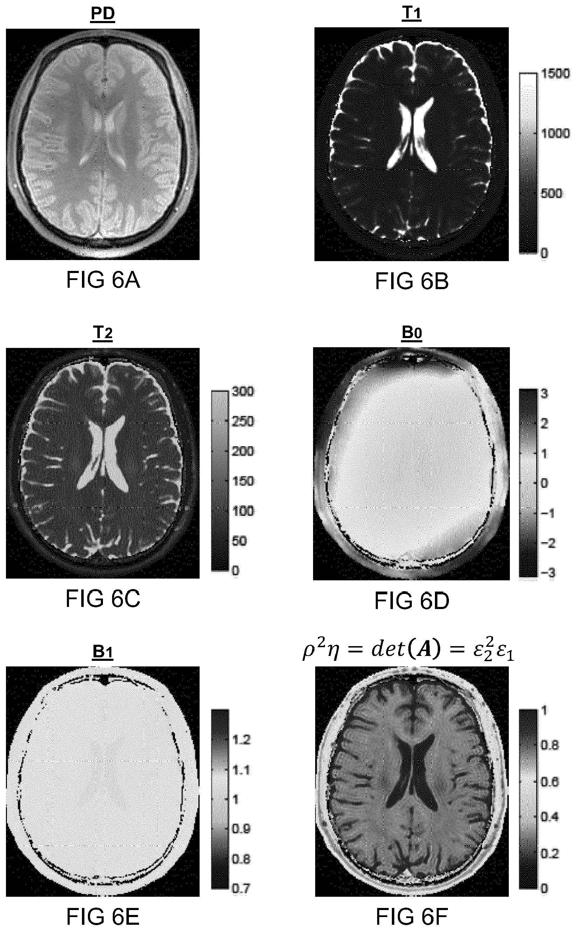

FIG 6 shows the results from the in-vivo scan. The parametric maps derived with the DCHO model are shown. Top row shows PD (proton density, a.u.), $T_1$ (ms); middle row shows $T_2$ (ms), $B_0$ (deviation in static magnetic field; rad/ms); Bottom row shows $B_1$ (excitation RF field scaling factor), and $\rho^2\eta = det(\boldsymbol{A}) = \varepsilon_2^2\varepsilon_1$ (HO: Harmonic Oscillator), estimated from the phase alternating split propagator ($\alpha_x$ - $\gamma_y$ - $\alpha_y$ - $\gamma_x$).

The acquisition scheme was the same applied to the standardized phantom. Besides the usual parametric maps (PD, $T_1$, $T_2$) an additional map can be derived that we named the harmonic oscillator (HO) map. The HO map is the determinant map of the propagator which is essentially the total dissipation during the entire propagator block. The HO map can be considered a quantitative map derived from a combination of T1 and T2, but free of system imperfections as the $B_0$ and $B_1^+$. They are all part of the analytical model and estimated simultaneously as well.

All these maps were obtained simultaneously in one measurement using the model and the "MP-b-nSSFP" sequence described in the present disclosure. To our knowledge, this the first time that multi-parametric maps have been obtained non-heuristically from a transient MR signal response without necessity of a dictionary. The quality and consistency of these maps demonstrate the "in-vivo" applicability of this technique.

It will be appreciated that various aspects as described herein can be embodied in practical applications for improving methods and systems related to (nuclear) magnetic resonance imaging such as an MRI device. Some aspects may also be embodied e.g. as a (non-transitory) computer readable medium with software instructions which when executed by an MRI device cause imaging as described herein. While many applications and advantages may already be apparent from the above discussion, we will highlight some of the more preferred aspects in the following. Of course it will be understood that any of these aspects can also be combined with any further teaching having the benefit of the present disclosure.

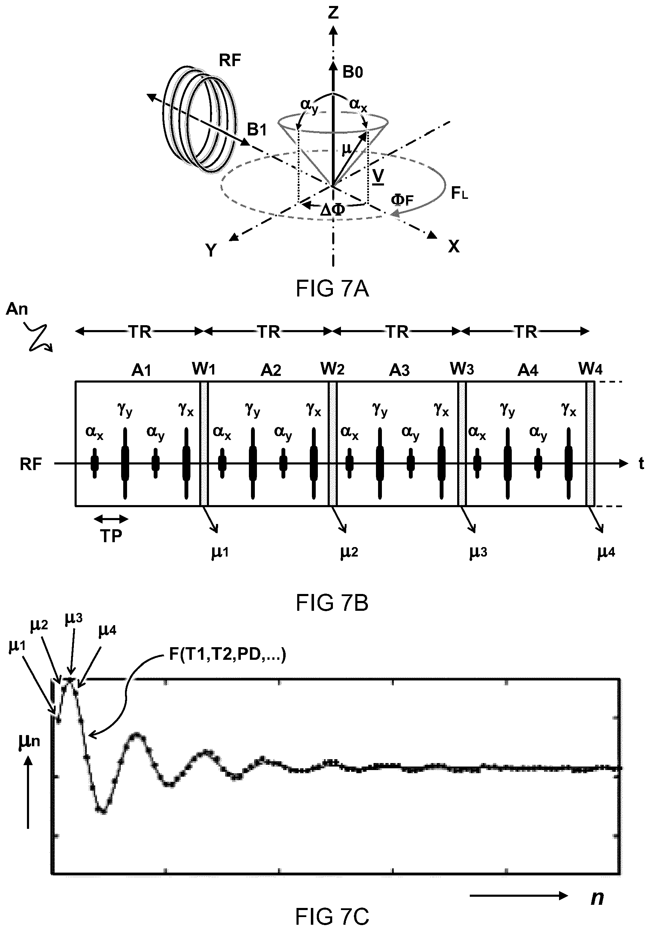

FIGs 7A-7C illustrate a method for measuring (nuclear) magnetic resonance, MR, properties of spin systems in a target volume V.

In one embodiment, a main magnetic field B0 is applied to the target volume V along a longitudinal axis Z. In another or further embodiment, an excitation sequence An is applied applying to the target volume V. In a preferred embodiment, as described herein, the sequence comprises a repeated sub-sequence or block A of excitation pulses. In some embodiments, a set of response signals $\mu_n$ is measured e.g. as a function of block number n. The response signals can be indicative of respective magnetization $\mu$ of the spin systems from the target volume V, e.g. in a respective one or more measurement windows W for each block A which typically follow one or more of the excitation pulses (in that block). In some embodiments, the MR properties of the target volume V are determined based on the set of response signals.

In a preferred embodiment, as illustrated e.g. in FIG 7B, each block A comprises a set of at least four radio frequency, RF, pulses. Most preferably, the set includes at least two small angle RF pulses and at least two large angle RF pulse. A first small angle RF pulse $\alpha_x$ is configured to apply a small flip angle $\alpha$ of less than ninety degrees along a first transverse axis X which is transverse to the longitudinal axis Z. A first large angle RF pulse $\gamma_y$ is configured to apply a large flip angle y of more than ninety degrees along a second transverse axis Y which is transverse to the longitudinal axis Z and transverse to the first transverse axis X. A second small angle RF pulse $\alpha_y$ is configured to apply the same small flip angle $\alpha$ as the first small angle pulse $\alpha x$ but along the second transverse axis Y. A second large angle RF pulse $\gamma_x$ configured to apply the same large flip angle $\gamma$ as the first large angle pulse $\gamma y$ but along the first transverse axis X.

As described herein, the inventors find that this combination of pulses which alternatingly flip and refocus the magnetization along different axes can provide a magnetization vector which develops from block to block along an essentially three dimensional trajectory. In essence, the switching of axes forces off-resonance which means the resulting trajectory of the magnetization is not restricted e.g. to the XZ (or YZ) plane. As a consequence, this trajectory can carry additional information of the underlying system, such as deviation in static magnetic field (B0), which information would be lost on-resonance. At the same time, while such off-resonance excitation is normally undesirable since it deteriorates the signal, in this case the signal is continually refocused in each block (and within the block) by the specific symmetries of pulses.

In one embodiment, e.g. as shown in FIG 7A, the excitation sequence comprises RF pulses with an oscillating magnetic field B1 along at least one transverse axis X,Y, orthogonal to the longitudinal axis Z. The excitation or acquisition sequence typically also comprises a set of magnetic field gradients (not shown here), e.g. used for localizing the excitation to a specific volume and/or for generating a gradient echo. In another or further embodiment, one or more receiver coils are arranged for converting a transverse component of the magnetization (along one or more of the traverses axes X,Y) into an electric signal which is measured. This can be the same or different RF coil used for delivering excitation pulses.

It will be understood that the application of RF pulses along different axes (X,Y) is equivalent to applying the RF pulses with a specific relative phase ($\Delta\Phi$) compared to a phase $\Phi_F$ of the frame of the induced magnetization vector $\mu$ rotating around the longitudinal axis Z with the Larmor frequency ($F_L$). So when a second RF pulse is applied in different direction with respect to a first RF pulse this is equivalent to applying the second RF pulse with a different (carrier) phase relative to the phase $\Phi_F$ of the rotating frame, compared to the phase of the first pulse (relative to the to the phase $\Phi_F$ of the rotating frame). It will also be understood that the oscillating B1 field of the RF pulses can be applied along any one or more axes in the rotating frame orthogonal to the B0 field which is along the longitudinal axis Z, shifting the phase $\Phi_F$ accordingly.

In some embodiments, the phase of the initial pulse is not important, only the relative phase of subsequent pulses. In other or further embodiments, small deviation in the (relative) phase may be tolerated. So as described herein, where a specific axis (X,Y) is indicated it will be understood that the relative phase (e.g. ninety degrees for orthogonal axes) may have a small deviation, e.g. less than ten degrees, preferably less than five degrees, most preferably less than one degree, or as small as possible.

The first large angle RF pulse $\gamma_y$ is preferably applied in an orthogonal direction (+y), i.e. ninety degrees out of phase, with respect to the first small angle RF pulse $\alpha_x$; or, alternatively, in the opposite (also orthogonal) direction (-y), i.e. two hundred seventy degrees out phase. The second small angle RF pulse $\alpha_y$ is preferably applied in the same direction (+y), i.e. with the same phase, as the first large angle RF pulse $\gamma_y$; or, alternatively, in the opposite direction (-y), i.e. hundred eighty degrees out phase. The second large angle RF pulse $\gamma_x$ is preferably applied in the same direction (+x), i.e. with the same phase, as the first small angle RF pulse $\alpha_x$; or, alternatively, in the opposite direction (-x), i.e. hundred eighty degrees out phase.

FIG 7C illustrates an example graph of the progression or development of the magnetization pn, as function of the sequence or block number "n". the magnetization $\mu_n$ measured as function of block number n. In principle various MR properties can be derived based on such measurements. For example, the measured magnetization as function of block number can be fitted to a (continuous) function "F" whose shape depends on parameters which can be characteristic of a specific tissue.

In one embodiment, the resulting magnetization $\mu$ is measured as a discrete sequence of response signals. For example, a respective response signal is acquired during a respective one or more acquisition windows W of a respective block A. In one embodiment, the sequence of (transient) response signals represents sequential evolution of the magnetization state $\mu$ resulting from a combination of manipulating of spin systems in the target volume by the blocks as well as intrinsic properties (such as PD, T1,T2) of the spin systems to be imaged. For example, the response signals are measured in the respective acquisition windows per block during a transient phase before a steady state response signal to the consecutive series of blocks develops.

In one embodiment, the discrete sequence of response signals is fitted to a fit function F that is based on an analytically modeled evolution of the magnetization state. For example, a shape of the fit function is determined by a set of fit parameters related to intrinsic properties PD,T1,T2 of the spin systems to be imaged and/or experimental settings. In some embodiments, the fit function F is a closed form expression that is continuously dependent on a variable n which at integer values equals a sequence number of the respective block "An" and corresponding response signal.

In one embodiment, the magnetization is modeled as a three dimensional magnetization vector, wherein an effect of a block on the magnetization is modeled using matrices as operators on the magnetization vector. For example, consecutive application of blocks is modelled as repeated multiplication by an operator matrix, wherein the repeated matrix multiplication is calculated using eigenvalues of the operator matrix. For example, the modelled fit function is based on a projection of the magnetization vector in a measurement direction of the measured responses. In some embodiments, a shape of the fit function is determined according to the analytically modelled evolution based at least on the experimental settings such as the repetition time TR, the specific choice of flip angles $\alpha$ and $\gamma$, the waiting time or phase evolution β' as well as intrinsic parameters $r,\lambda_3,\varphi,\delta$ to be fitted. Accordingly the intrinsic parameters can be related to the intrinsic properties PD,T1,T2 of the spin systems to be imaged. Of course also other models can be used.

In some embodiments, an image of the target volume V is determined based on at least one of the set of fit parameters which match the fit function to the discrete sequence of response signals. In a preferred embodiment, the fit function has both dissipative and oscillatory terms. For example, the fit function is of the form

$$F_n = a \cdot e^{-|ln\, r| \cdot n} \cos(\varphi n + \delta) + b \cdot e^{-|ln\, \lambda_3| \cdot n} + c \ ,$$

where $F_n$ is the value of the function to be fitted for the respective measurement of block number n; and a, b, c, $\varphi$, $\delta$, $r$, $\lambda_3$ are fit parameters. In principle, an image of the target volume V can be constructed based directly on fitted values of one or more fit parameters in the fit function F. Alternatively, the fitted values can be converted to the more familiar properties such as T1,T2.

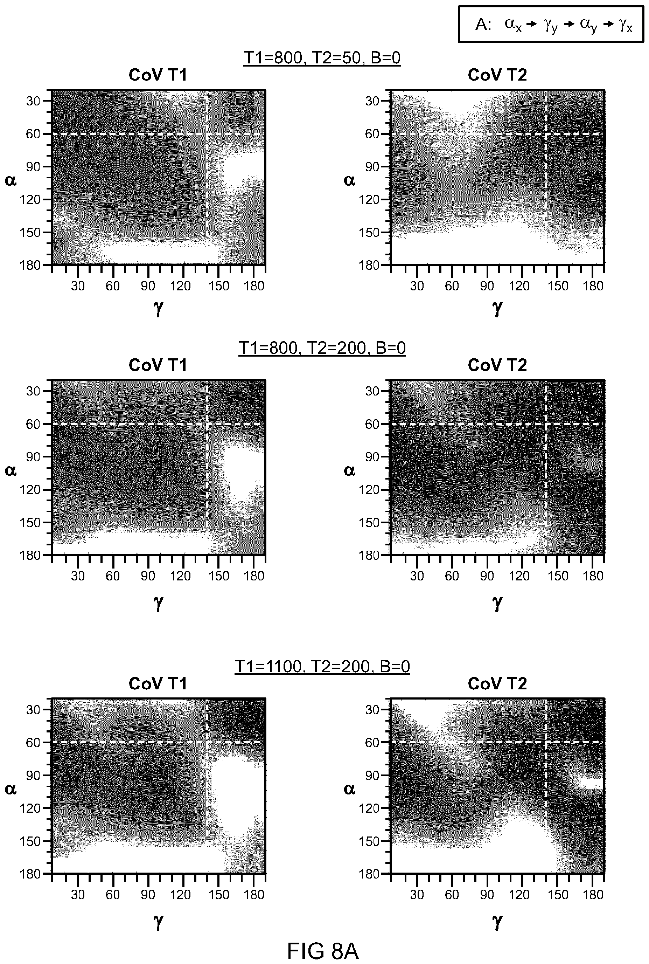

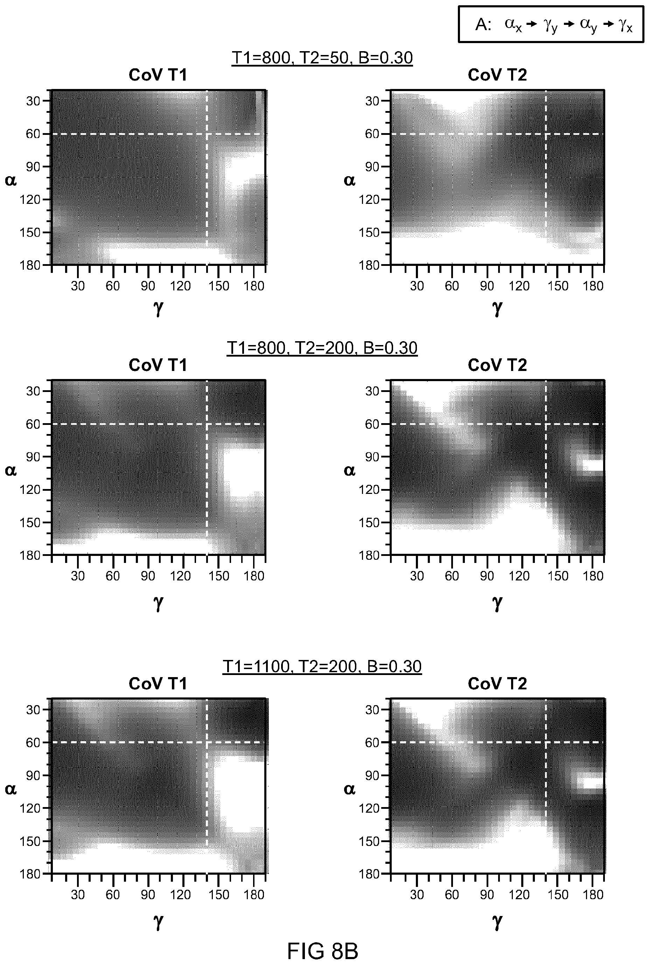

FIGs 8A and 8B illustrates representative graphs which can be used to verify an optimal combination of small and larger flip angles $\alpha,\gamma$ in a sequence ($\alpha$x,$\gamma$y,$\alpha$y,$\gamma$x) applied to typical tissue with the indicated values for T1 and T2, in different combination, T1=800ms, T2=50ms (top); T1=800,T2=200 (middle); T1=1100 ms, T2=200ms (bottom). The grayscale indicates the suitability of the respective combination. Specifically, the brightness of respective areas in the graph indicates a magnitude of the square root of a diagonal element of the Cramer Rao Lower bound matrix (CRLBs), which gives a good prediction for the standard deviation of the respective parameters in actual experiments. Hence the figures show the CRLBs divided by the nominal value for T1 and T2 to predict the respective coefficient of variation (CoV) that can be expected in actual experiments upon a global scaling factor that linearly relates to the noise level in the experiment. The graphs in FIG 8A are without magnetic field inhomogeneity (B=0 rad/ms); whereas in FIG 8B there is inhomogeneity (B=0.30 rad/ms). It may be noted that the corresponding graphs of FIGS 8A and 8B are very similar, illustrating that the inhomogeneity has only small effect on the determination of T1 and T2.

The terms "large" and "small" flip angles pulses are used herein to distinguish the different type of pulses based on their relative flip angle being relatively large or small, e.g. more or less than ninety degrees. In some embodiments, the small flip angles $\alpha_x, \alpha_y$ are between ten and eighty degrees, preferably between fifteen and sixty degrees, most preferably between twenty and forty degrees, e.g. thirty degrees (plane angle). In other or further embodiments, the large flip angles $\gamma_x, \gamma_y$ are between hundred twenty and hundred eighty degrees, preferably at least one hundred forty degrees, one hundred fifty degrees, or one hundred sixty degrees, and most preferably equal or less than one hundred seventyfive degrees, e.g. one hundred sixty degrees.

It will be noted that while these ranges, especially in combination, can provide particularly optimal behavior of the system for the measurements as described herein, in principle also other combinations of flip angles can be used to provide at least some of the benefits. For example, the graphs show that also a combination of only large flip angles can provide relatively low CoV. However, also other factors may be taken into consideration, e.g. maximum energy deposition in the tissue. This is one reason why the combination of small and large flip angles is most preferred.

Most preferably, in each block A, the set of RF pulses are applied in a sequence $\alpha, \gamma, \alpha, \gamma$ interleaving the small angle RF pulses $\alpha_x, \alpha_y$ with the large angle RF pulses $\gamma_x, \gamma_y$. Advantageously, using this sequence, after any large flip angle $\gamma x, \gamma y$ pulse, the signal can be refocused before the next small flip angle $\alpha x, \alpha y$ providing the desired transversal signal after any "alpha" pulse. At the same time, the phase accumulates a constant precession angle, due to field inhomogeneities, local susceptibility gradients or chemical shift after any "alpha" - thus improving sensitivity to B0 field inhomogeneities.

In one embodiment, the RF pulses are applied in a sequences with the first small angle pulse $\alpha_x$ followed by the first large angle pulse $\gamma_y$ followed by the second small angle pulse $\alpha_y$ followed by the second large angle pulse $\gamma_x$; or a cyclic variant thereof. For example, each block may comprise a sequences selected from: $\{\alpha x, \gamma x, \alpha y, \gamma y\}$; $\{\alpha x, \gamma y, \alpha y, \gamma x\}$; $\{\alpha y, \gamma y, \alpha x, \gamma x\}$; $\{\alpha y, \gamma x, \alpha x, \gamma y\}$.

In some embodiments, , in each block A, the set of RF pulses are applied in a sequence $\alpha, ..., \gamma$ starting with one of the small angle RF pulses $\alpha_x, \alpha_y$ and ending with one of the large angle RF pulse $\gamma_x, \gamma_y$, wherein at least one measurement window W follows directly after a large angle RF pulse $\gamma_x, \gamma_y$ Advantageously, beginning with a small flip angle and ending with a large flip angle, may refocus the magnetization after each block. On the other hand, since the blocks are repeated, and in principle, the measurement window W can be between any two pulses, the block can also start with a large flip angle $\gamma$ pulse and end with a small flip angle $\alpha$ pulse. Additionally, or alternatively, a measurement window can also be disposed directly following one of the small angle RF pulses $\alpha_x, \alpha_y$. This signal may in principle carry similar information.

In the sequence, the blocks are preferably repeated before the (transverse) signal has completely decayed. So the repetition time TR (from one block "An" to the next block "An"$_{+1}$) is ideally on the order of, or smaller than the transverse (spin-spin) relaxation time T2 of the spin systems to be measured. In a preferred embodiment, the blocks are repeated with a repetition time $T_R$ of less than two or three times T2. For example, the blocks are repeated with a (block) repetition time $T_R$ of less than hundred milliseconds, preferably less than sixty milliseconds, most preferably less than twenty milliseconds, e.g. between one and fifteen milliseconds. In principle, the shorter the repetition time, the faster the acquisition but this also has to be weighed against other factors such as system and tissue limitations.

Preferably, a variation or progressive development of the (transverse) magnetization $\mu$ is measured from block to block before a steady state response to the repeated blocks develops. So, the measurement time of all blocks in a sequence combined is preferably on the order of the longitudinal (spin-lattice) relaxation time T1 of the spin systems to be measured. In a preferred embodiment, the sequence of all blocks combined is extended over a period of at least a tenth of T1, e.g. up to T1, or longer. For example, the excitation sequence for determining a respective MR property comprises at least ten repeated blocks A1...A10, preferably at least twenty repeated blocks A1...A20, most preferably at least forty repeated blocks A1...A50, or more, e.g. between fifty and hundred repeated blocks. For example, as shown in FIG 4, the most information / signal is retrieved in the first fifty blocks.

In one embodiment, the RF pulses are applied with a pulse-to-pulse time Tp between subsequent RF pulses in each block A, wherein the pulse-to-pulse time Tp is less than fifty milliseconds, preferably between one and fifteen milliseconds, or less. For example, the limits may be determined by the measurement apparatus and/or maximum energy that can be safely deposited by the RF pulses.

Preferably, the set of RF pulses in each of the repeated blocks A is identical. While this provides the easiest and most predictable sequence, also variation, e.g. in the sequence of small and large angle pulses, within each block can be envisaged.

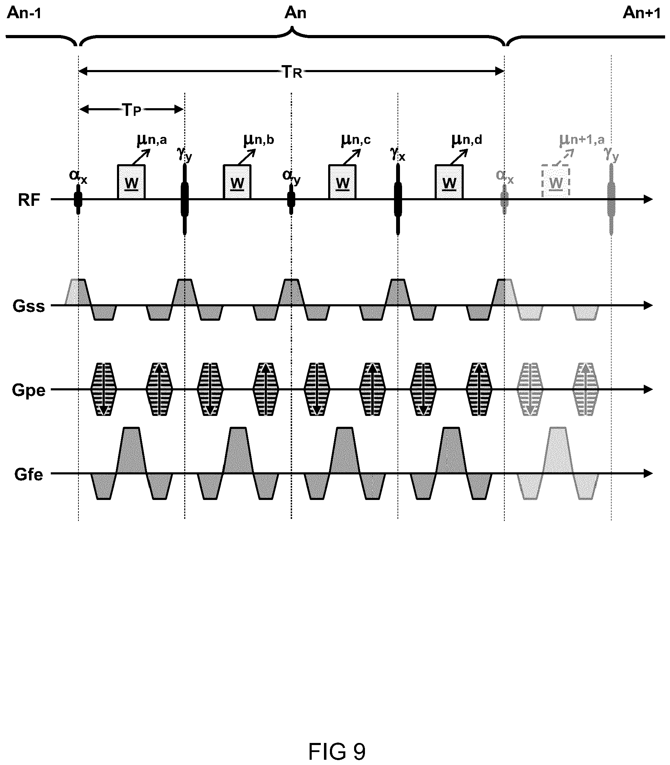

FIG 9 illustrates an example with a repeated block "An" in an MR sequence with Cartesian readout;

In some embodiments, in addition to the RF pulses, each block comprise a set of magnetic field gradients or gradient pulses G. For example, the gradient pulses can be used to generate a gradient echo and/orimprove, e.g. maximize a magnitude of, the measured signal in the measurement window W, also referred to as the echo time. Alternatively or additionally, the gradient pulses can be used for localizing the target volume V in an object.

In a preferred implementation, the present pulse sequence is used in magnetic resonance imaging (MRI). For example, one or more of the determined MR properties are used for generating a two or three dimensional image of an object comprising the target volume V. Also other types of MR measurements can be envisaged for obtaining various quantitative parametric maps of an object or volume.

In one embodiment, each block A comprises a set of magnetic field gradient pulses G for selecting sub regions to be imaged in the target volume V. In one embodiment, e.g. as shown, a slice select gradient Gss is applied during each RF pulse for selectively exciting the target volume in an object slice. In another or further embodiment, a phase encoding gradient Gpe is applied before (or during) each measurement window W for encoding a first spatial dimension of the target volume in the object slice. In another or further embodiment, a frequency encoding gradient Gfe is applied during each measurement window W for encoding a second spatial dimension of the target volume in the object slice.

The inventors find that the present sequences perform optimally when the gradient pulses G for each block are applied according to a balanced sequence. Preferably, the gradients are balanced at least from block-to-block. So for each applied gradient in a block "An" opposite gradient is applied to restore the phases before the next block. In some embodiments, e.g. as shown, the gradients are also balanced between subsequent pulses within each block. So for each applied gradient during and after a first pulse in a block "An" opposite gradient is applied to restore the phases before the next pulse in the same block.

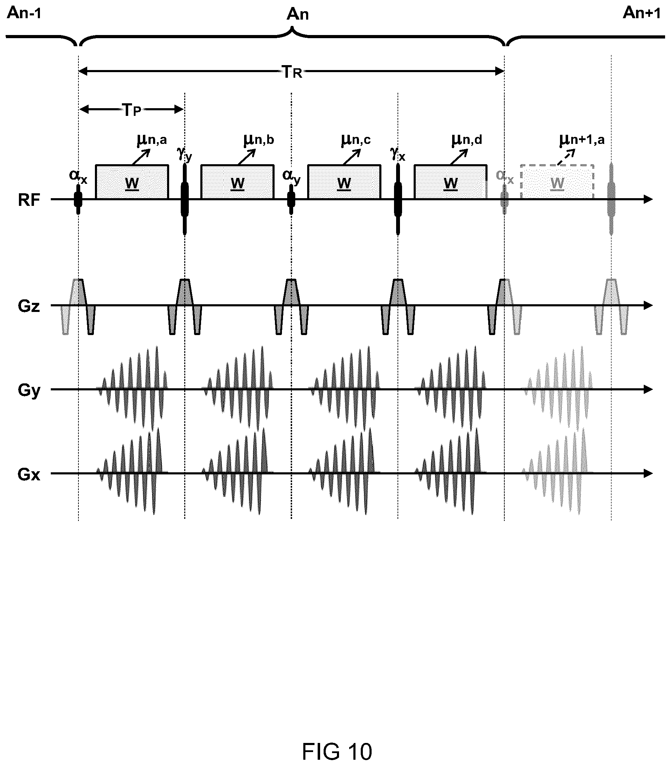

FIGs 9 and 10 illustrates that in principle the signal can be readout between each pulse to yield a respective indication of how the magnetization develops from block to block. These multiple readouts per block may provide additional information. In other or further embodiments (as shown in previous FIGs 1-7), the signal is only readout once per block, e.g. after the four subsequent pulses. For example, the phase encoding gradient Gpe and a frequency encoding gradient Gfe need only be applied once per block, optionally with the four pulses closer together. Also many other readout schemes can be envisaged in combination with the present sequence of RF pulses. In principle, each block can also have more than four pulses, e.g. six or eight pulses which alternate between small and large flip angles.

FIG 10 illustrates a repeated block "An" in an MR sequence with spiral readout. In a preferred embodiment, between every pair of adjacent RF pulses, the signal is sampled with balanced spiral-out k-space trajectory. Of course also other readout schemes can be used.

It will be understood that aspects of the present disclosure can be embodied as an MR device configured to perform operational acts as described herein. For example, an MRI device can be programmed to apply the present disclosed pulse sequence to a tissue and construct an image based on the response signals. In some embodiments, the MRI device comprises a lookup table for distinguishing different tissue types in the image based on one or more distinct fit values of intrinsic parameters depending on tissue type, as fitted to a measured sequence of response for a predetermined set of experimental settings. Aspects of the present disclosure can also be embodied as a computer program, e.g. a non-transitory computer readable medium with software instructions which when executed by an MRI device cause imaging with a pulse sequence as described herein.

*Appendix A*

The operator in FIG 1, $A_n$ updates the magnetization $\left(\mu_n \overset{A_n}{\rightarrow} \mu_{n+1}\right)$ along the train of acquisition blocks.

We focus on a special case, where the propagator $A$ is constant, i.e. the acquisition train is strictly repetitive. This constraint leads to a simple recursive formula:

$$\mu_{n+1} = A \cdot \mu_n \text{ , with the solution: } \mu_n = A^n \cdot \mu_0 \qquad \text{(A1a - A1b)}$$

where $\mu$ is the difference in magnetization from the steady-state and $\mu_0$ is the initial state. It is important to realize at this point that even if $A$ is constant, the set of events in the blocks along the train are not necessarily identical, however their cumulative effect is.

The recursive equation (Eqn. A1.b) is equivalent to a discrete-in-time equation of motion for the magnetization vector. Mathematically, this equation of motion is a very simple one: it is a linear, first order, homogenous and autonomous difference equation. The continuous analogue is the following vector differential equation:

$$\dot{y}(t) = A \cdot y(t), \text{ with the solution: } y(t) = e^{A \cdot t/T_R} \cdot y(0) , \qquad \text{(A2a - A2b)}$$

where $T_R$ is the duration of the block $A$.

Further time derivative of equation A2a leads to the familiar second order differential equation of motion of a system of dissipative coupled harmonic oscillators.

$$\ddot{y}(t) = A^2 \cdot y(t) \qquad \text{(A3)}$$

The propagator can be expressed as a 3x3 real-valued matrix. Its determinant, $\det(A) = \varepsilon_2^2 \, \varepsilon_1 \neq 0,$ where $\varepsilon_{1,2} = \exp(-T_R/T_{1,2})$; represents the total dissipation during the repetition time $T_R$. $A$ can be diagonalized and has three non-zero eigenvalues. This diagonalization is desirable as it allows derivation of an expression of $A^n$, which is used in equation 1.b. The diagonalization can be achieved by expansion with the eigenvectors [Hargreaves]. With the matrix $P$ formed from the eigenvectors of $A$, $\Lambda$ as a diagonal matrix with the eigenvalues of $A$, $\mu_n$ can be expressed as:

$$\mu_n = P \, \Lambda^n P^{-1} \cdot \mu_0 \qquad \text{(A4)}$$

This is a linear combination of the $n_{th}$ power of the eigenvalues. Unfortunately, the eigenvectors are complex-valued in most cases, therefore the expression in eqn.4. is not immediately useful for a closed-form expression in eqn. A1.b.

It is more useful to express the solution with the normal modes instead of the eigenmodes. As a consequence of the Cayley-Hamilton theorem, any function of a 3x3 matrix $A$ can be expressed as a function of $A$ and $A^2$. This expansion leads to the following exact equation:

$$A^n = \rho^n \cdot \sin(n\varphi) \cdot M_1 + \rho^n \cdot \cos(n\varphi) \cdot M_2 + \eta^n \cdot M_3 , \qquad \text{(A5)}$$

where the eigenvalues of $A$ are $\varrho e^{i\varphi}$, $\varrho e^{-i\varphi}$ and $\eta$.

The real-valued, normal modes are $v_1 = M_1 \bullet \mu_0$, $v_2 = M_2 \bullet \mu_0$ and $v_3 = M_3 \bullet \mu_0$ where $\mu_0$ is the initial state.

$$M_1 = \frac{A}{\rho \cdot \sin\varphi} - \frac{I \cdot \cos\varphi}{\sin\varphi} + \left( -\frac{\eta}{\rho} + \cos\varphi \right) \cdot M_3$$

$$M_2 = I - M_3$$

$$M_3 = \frac{(A^2 + \varrho^2 I - 2\varrho \cdot \cos\varphi \cdot A)}{\rho^2 + \eta^2 - 2\varrho \cdot \eta \cdot \cos\varphi} \qquad \text{(A6)}$$

The application of A5 over the initial magnetization state generates the expression shown in equation 1.

Equation A5 describes two modes exhibiting decaying oscillations with the same frequency and with a constant relative phase. The third mode exhibits an exponential decay. The temporal evolution is neatly separated into oscillatory and exponential decay coefficients determined by the eigenvalues of A. The advantage of this normal mode expansion over the eigenvector expansion is that the resulting expression is real and the modes are easy to interpret and visualize. The expression A5 is in effect providing a new set of coordinates. Choosing the normal modes as a coordinate system, the magnetization is described as three uncoupled oscillators. The oscillation is in a plane where the trajectory of magnetization is along a circle with exponentially decreasing radius.

In general, the normal mode vectors are not orthogonal. They do not necessarily form a complete set either in 3D. As illustrated in FIG 2 in case of on-resonance $|v_3| = 0$. Nevertheless, they always span the subspace that contains the trajectory of the magnetization. In case of the off-resonance to on-resonance transition, the dimensionality of the trajectory collapses: 3D → 2D. This poses a serious problem in quantification. The signal evolution does not contain information about $\eta$ in the on-resonance case (see equation A5). In practical MR, the problem of off-resonance cannot be fully controlled. An important task in the design of the propagator is to avoid such a dimensionality reduction at any possible frequency offset. In other words, the propagator preferably should guarantee that the trajectory of the magnetization evolution remains a 3D object for any frequency offset.

For the purpose of clarity and a concise description, features are described herein as part of the same or separate embodiments, however, it will be appreciated that the scope of the invention may include embodiments having combinations of all or some of the features described. Although we focus here on the concept, its proof and feasibility on actual clinical scanners, it is straightforward to translate these results to other fields in magnetic resonance such as multi-parametric proton NMR spectroscopy, dynamic contrast enhanced MRI, dynamic susceptibility contrast MRI, MR Thermometry and to extend the model with diffusion weighting and magnetization transfer.

In interpreting the appended claims, it will understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A method for measuring magnetic resonance, MR, properties of spin systems in a target volume (V), the method comprising

   applying a main magnetic field (B0) to the target volume (V) along a longitudinal axis (Z);
   applying an excitation sequence (An) comprising a repeated block (A) of excitation pulses to the target volume (V);
   measuring a set of response signals ($\mu_n$) indicative of respective magnetization ($\mu$) of the spin systems from the target volume (V) in a respective one or more measurement windows (W) for each block (A) following one or more of the excitation pulses; and
   determining the MR properties of the target volume (V) based on the set of response signals;
   wherein each block (A) comprises a set of radio frequency, RF, pulses including at least

   a first small angle RF pulse ($\alpha_x$) configured to apply a small flip angle ($\alpha$) of less than ninety degrees along a first transverse axis (X) which is transverse to the longitudinal axis (Z);
   a first large angle RF pulse ($\gamma_y$) configured to apply a large flip angle ($\gamma$) of more than ninety degrees along a second transverse axis (Y) which is transverse to the longitudinal axis (Z) and transverse to the first transverse axis (X);
   a second small angle RF pulse ($\alpha_y$) configured to apply the same small flip angle ($\alpha$) as the first small angle pulse ($\alpha_x$) but along the second transverse axis (Y);
   a second large angle RF pulse ($\gamma_x$) configured to apply the same large flip angle ($\gamma$) as the first large angle pulse ($\gamma_y$) but along the first transverse axis (X).

2. The method according to claim 1, wherein the small flip angles ($\alpha_x$,$\alpha_y$) are between fifteen and sixty degrees.

3. The method according to any of the preceding claims, wherein the large flip angles ($\gamma_x$,$\gamma_y$) are between one hundred forty and one hundred seventyfive degrees.

4. The method according to any of the preceding claims, wherein, in each block (A), the set of RF pulses are applied in a sequence ($\alpha$,$\gamma$,$\alpha$,$\gamma$) interleaving the small angle RF pulses ($\alpha_x$,$\alpha_y$) with the large angle RF pulses ($\gamma_x$,$\gamma_y$).

5. The method according to any of the preceding claims, wherein the RF pulses are applied in a sequences with the first small angle pulse ($\alpha_x$) followed by the first large angle pulse ($\gamma_y$) followed by the second small angle pulse ($\alpha_y$) followed by the second large angle pulse ($\gamma_x$).

6.   The method according to any of the preceding claims, wherein, in each block (A), the set of RF pulses are applied in a sequence ($\alpha,...,\gamma$) starting with one of the small angle RF pulses ($\alpha_x,\alpha_y$) and ending with one of the large angle RF pulse ($\gamma_x,\gamma_y$), wherein at least one measurement window (W) follows directly after a large angle RF pulse ($\gamma_x,\gamma_y$)

7.   The method according to any of the preceding claims, wherein the blocks (A) are repeated with a repetition time ($T_R$) of less than hundred milliseconds.

8.   The method according to any of the preceding claims, wherein the excitation sequence for determining a respective MR property comprises at least twenty repeated blocks.

9.   The method according to any of the preceding claims, wherein the RF pulses are applied with a pulse-to-pulse time (Tp) between subsequent RF pulses in each block (A), wherein the pulse-to-pulse time (Tp) is between one and fifteen milliseconds.

10.  The method according to any of the preceding claims, wherein each block comprise a set of magnetic field gradients or gradient pulses (G) used to produce a maximum magnitude of the signal in the measurement window (W) and/or for localizing the target volume (V) in an object.

11.  The method according to any of the preceding claims, wherein one or more of the determined MR properties are used for generating a two dimensional image of an object comprising the target volume (V).

12.  The method according to any of the preceding claims, wherein the gradient pulses (G) for each block are applied according to a balanced sequence.

13.  The method according to any of the preceding claims, wherein between every pair of adjacent RF pulses the signal is sampled with balanced spiral-out k-space trajectory.

14.  An MRI device configured to execute the method according to any of the preceding claims for imaging an object.

15.  A non-transitory computer readable medium with software instructions which when executed causes an RF coil in an MR device to generate a sequence of repeated blocks,
     wherein each block (A) comprises a set of radio frequency, RF, pulses including at least

     a first small angle RF pulse ($\alpha_x$) configured to apply a small flip angle ($\alpha$) of less than ninety degrees along a first transverse axis (X) which is transverse to the longitudinal axis (Z);
     a first large angle RF pulse ($\gamma_y$) configured to apply a large flip angle ($\gamma$) of more than ninety degrees along a second transverse axis (Y) which is transverse to the longitudinal axis (Z) and transverse to the first transverse axis (X);
     a second small angle RF pulse ($\alpha_y$) configured to apply the same small flip angle ($\alpha$) as the first small angle pulse ($\alpha_x$) but along the second transverse axis (Y);
     a second large angle RF pulse ($\gamma_x$) configured to apply the same large flip angle ($\gamma$) as the first large angle pulse ($\gamma_y$) but along the first transverse axis (X).

FIG 1A

FIG 1B

FIG 2A

FIG 2B

FIG 2C

FIG 2D

FIG 2E

FIG 2F

FIG 3A

FIG 3B

FIG 3C

FIG 3D

FIG 3E

FIG 4

FIG 5A

FIG 5B

**PD**

**T1**

FIG 6A

FIG 6B

**T2**

**B0**

FIG 6C

FIG 6D

**B1**

$$\rho^2 \eta = det(A) = \varepsilon_2^2 \varepsilon_1$$

FIG 6E

FIG 6F

FIG 7A

FIG 7B

FIG 7C

A: $\alpha_x \rightarrow \gamma_y \rightarrow \alpha_y \rightarrow \gamma_x$

T1=800, T2=50, B=0

**CoV T1**

**CoV T2**

T1=800, T2=200, B=0

**CoV T1**

**CoV T2**

T1=1100, T2=200, B=0

**CoV T1**

**CoV T2**

FIG 8A

FIG 8B

FIG 9

FIG 10

Europäisches
Patentamt

European
Patent Office

Office européen
des brevets

# EUROPEAN SEARCH REPORT

Application Number

EP 20 17 2381

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 291 996 B1 (GLOVER PAUL MARTIN [GB] ET AL) 18 September 2001 (2001-09-18) * abstract; claims 1-6,20 * * column 1, line 60 - column 4, line 66; figures 2,3,5,6a,6b,8 * * column 6, line 40 - line 59 * ----- | 1-15 | INV. G01R33/44 G01R33/50 |
| A | WANG GUAN ET AL: "Minimum acquisition methods for simultaneously imagingT1,T2, and proton density withB1correction and no spin-echoes", JOURNAL OF MAGNETIC RESONANCE, ACADEMIC PRESS, ORLANDO, FL, US, vol. 242, 1 March 2014 (2014-03-01), pages 243-255, XP028644584, ISSN: 1090-7807, DOI: 10.1016/J.JMR.2014.02.010 * figures 7-9 * ----- | 1-15 | |
| A | US 2012/112743 A1 (GRANLUND KRISTIN L [US] ET AL) 10 May 2012 (2012-05-10) * paragraphs [0021] - [0024], [0039], [0052]; claim 12 * ----- | 1-15 | |
| A,D | WO 2020/046120 A1 (UNIV ERASMUS MED CT ROTTERDAM [NL]) 5 March 2020 (2020-03-05) * the whole document * ----- | 1-15 | |

TECHNICAL FIELDS
SEARCHED     (IPC)

G01R

The present search report has been drawn up for all claims

| Place of search | Date of completion of the search | Examiner |
|---|---|---|
| Munich | 28 October 2020 | Faber-Jurk, Sonja |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

# EP 3 904 898 A1

## ANNEX TO THE EUROPEAN SEARCH REPORT
## ON EUROPEAN PATENT APPLICATION NO.

EP 20 17 2381

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2020

| Patent document cited in search report | | Publication date | Patent family member(s) | | Publication date |
|---|---|---|---|---|---|
| US 6291996 | B1 | 18-09-2001 | EP | 1004034 A1 | 31-05-2000 |
| | | | JP | 2001515736 A | 25-09-2001 |
| | | | US | 6291996 B1 | 18-09-2001 |
| | | | WO | 9909428 A1 | 25-02-1999 |
| US 2012112743 | A1 | 10-05-2012 | NONE | | |
| WO 2020046120 | A1 | 05-03-2020 | EP | 3617731 A1 | 04-03-2020 |
| | | | WO | 2020046120 A1 | 05-03-2020 |

EPO FORM P0459

For more details about this annex : see Official Journal of the European Patent Office, No. 12/82

28

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 20200046120 A

### Non-patent literature cited in the description

- **MA D ; GULANI V ; SEIBERLICH N ; LIU K ; SUNSHINE JL ; DUERK JL et al.** Magnetic resonance fingerprinting. *Nature,* 2013, vol. 495 (7440), 187
- **LUSTIG M ; DONOHO DL ; SANTOS JM ; PAULY JM.** Compressed sensing MRI. *IEEE signal processing magazine,* 2008, vol. 25 (2), 72
- **GÓMEZ PA ; MOLINA-ROMERO M ; BUONINCONTRI G ; MENZEL MI ; MENZE BH.** Designing contrasts for rapid, simultaneous parameter quantification and flow visualization with quantitative transient-state imaging. *Scientific reports,* 2019, vol. 9 (1), 8468
- **SKINNER TE.** Comprehensive solutions to the Bloch equations and dynamical models for open two-level systems. *Physical Review A,* 2018, vol. 97 (1), 013815
- **TORREY HC.** Transient Nutations in Nuclear Magnetic Resonance. *Physical Review,* 1949, vol. 76 (8), 1059-68
- **JAYNES ET.** Matrix treatment of nuclear induction. *Phys Rev.,* 1955, vol. 98 (4), 1099-105
- **BLOOM BLOOM AL.** Nuclear induction in inhomogeneous fields. *Physical Review,* 1955, vol. 98 (4), 1105
- **LIANG Z-P ; LAUTERBUR PC.** Principles of magnetic resonance imaging: a signal processing perspective. SPIE Optical Engineering Press, 2000
- **SCHEFFLER K.** On the transient phase of balanced SSFP sequences. *Magn Reson Med.,* 2003, vol. 49 (4), 781-3